# EUROPEAN PATENT SPECIFICATION

(11) **EP 2 719 985 B1**
(45) Date of publication and mention of the grant of the patent: **26.08.2015**
(21) Application number: 12007006.5
(22) Date of filing: 09.10.2012
(51) Int. Cl.: F28F 3/12, F28F 9/02, F28F 13/12, H01L 23/473

(54) **A flow distribution module with a patterned cover plate**
Durchflussverteilungsmodul mit einer gemusterten Deckplatte
Module de distribution de flux avec plaque de couverture à motifs

(43) Date of publication of application: 16.04.2014
(73) Proprietor: Danfoss Silicon Power GmbH, 24941 Flensburg (DE)
(72) Inventor: Bredtmann, Rüdiger, D-24857 Fahrdorf (DE); Klaus, Olesen, DK-6400 Soenderborg (DK); Lars, Paulsen, D-25788 Hollingstedt (DE); Holger, Ulrich, D-24589 Eisendorf (DE)
(74) Representative: Copsey, Timothy Graham

(56) References cited:
- WO-A1-2005/040709
- US-A1- 2005 011 635
- US-A1- 2009 114 372
- US-A1- 2010 090 336
- US-A1- 2011 132 591

## Description

### FIELD OF THE INVENTION

The present invention relates to a flow distribution module for distributing a flow of fluid over a surface to be cooled. The flow distribution module of the invention is capable of cooling the surface in a very efficient manner. A flow distribution module according to the preamble of claim 1 is known from US 2011/0132591 or US 2005/0011635.

### BACKGROUND OF THE INVENTION

Flow distribution modules for distributing a flow of fluid over a surface to be cooled, thereby providing cooling for the surface, have previously been provided. For instance, WO 2005/040709 discloses a flow distribution unit and cooling unit in which a plurality of flow cells are arranged to convey a flow of fluid over a surface to be cooled. The flow cells are connected fluidly in parallel between an inlet manifold and an outlet manifold, and the flow cells may define meandering flow paths. DE 202 08 106 U1 discloses a similar cooling device.

In the distribution units disclosed in WO 2005/040709 and DE 202 08 106 U1 the surface being cooled is substantially plane.

### DESCRIPTION OF THE INVENTION

It is an object of embodiments of the invention to provide a flow distribution module in which heat transfer from a surface to be cooled to fluid flowing in the flow distribution module is improved as compared to prior art flow distribution modules.

It is a further object of embodiments of the invention to provide a flow distribution module in which the risk of clogging of the flow distribution module is minimised.

It is an even further object of embodiments of the invention to provide a flow distribution module in which pressure drop of fluid flowing through the flow distribution module is minimised.

The invention provides a flow distribution module for distributing a flow of fluid over a surface to be cooled according to claim 1.

The flow distribution module of the invention is adapted to distribute a flow of fluid over a surface to be cooled. Thus, when fluid flows through the flow distribution module, it flows along the surface, and thereby heat is transferred from the surface to the fluid flowing in the flow distribution module. Accordingly, the fluid conveys the heat away from the surface, and the surface is thereby cooled.

The fluid flowing in the flow distribution module may advantageously be a liquid, such as water or a mixture of ethylene-glycol and water. As an alternative, the fluid may be a two-phase refrigerant, such as R134a. As another alternative, the fluid may be gaseous.

The flow distribution module comprises a housing defining at least one flow cell. Each flow cell has an inlet opening arranged to receive fluid and an outlet opening arranged to deliver fluid. Accordingly, fluid can be received at the inlet opening, flow through the flow cell, via a flow path defined by the flow cell, and finally be delivered from the flow cell at the outlet opening. The flow cell(s) is/are arranged in such a way that when fluid flows through the flow cell(s) as described above, the fluid is conveyed over the surface to be cooled. Accordingly, heat is transferred from the surface to the fluid flowing in the flow cell(s).

Each flow cell is formed to cause at least one change in the direction of flow of the fluid flowing through the flow cell. When the direction of flow of the fluid flowing through a flow cell is changed, the fluid is swirled. Thereby the hot fluid, which is in direct contact with the surface to be cooled, is mixed with the cooler fluid flowing at a distance to the surface to be cooled. This allows the cooling capacity of the fluid to be utilised fully. Furthermore, the swirl provided by the change in direction of flow of the fluid in itself forces the fluid towards the surface to be cooled in a beneficial manner. This will be described further below.

The flow cell(s) may advantageously be formed to cause a plurality of changes in the direction of flow of the fluid flowing through the flow cell(s). Thereby the swirl of the fluid is even more significant.

The flow distribution module further comprises a cover plate arranged adjacent to the flow cell(s). The cover plate defines the surface to be cooled. For instance, the surface to be cooled may be a surface of the cover plate which faces the flow cell(s), i.e. which is arranged directly in contact with the fluid flowing in the flow cell(s).

At least a part of the surface to be cooled is provided with a surface pattern of raised and depressed surface portions. Thereby the surface area of the surface to be cooled is enlarged as compared to a similar surface which is substantially plane. Accordingly, the contact area between the surface to be cooled and the fluid flowing in the flow cell(s) is increased, and thereby the transfer of heat from the surface to be cooled to the fluid flowing in the flow cell(s) becomes more efficient.

It should be noted that the raised and depressed surface portions of the surface pattern are 'raised' and 'depressed' relative to each other in the sense that the raised surface portions are arranged further away from a surface of the cover plate arranged opposite to the surface to be cooled, than the depressed surface portions. The surface pattern may be provided in such a manner that the depressed surface portions are arranged at a level corresponding to the level of a part of the surface to be cooled which is not provided with the surface pattern, while the raised surface portions protrude outwards from this level. As an alternative, the raised surface portions may be arranged at said level, while the depressed surface portions protrude into the cover plate from this level. As another alternative, the raised surface portions may protrude outwards from said level, while the depressed surface portions protrude into the cover plate from said level.

In order to utilise the enlarged surface area of the surface to be cooled, which is provided by the surface pattern, it must be ensured that the fluid flowing in the flow cell(s) is brought into contact with the entire enlarged surface. Thus, the fluid must be forced 'into' the surface pattern. This can, e.g., be achieved by designing the flow cell(s) in such a manner that the cross sectional area of the flow path(s) defined by the flow cell(s) is small, thereby forcing the fluid to follow the raised and depressed surface portions closely. However, this has the disadvantage that the risk of clogging of the flow path(s) is very high. Furthermore, a large pressure drop of the fluid flowing through the flow cell(s) must be expected.

However, in the flow distribution module according to the invention, the flow cell(s) is/are formed to cause at least one change in the direction of flow of the fluid flowing through the flow cell(s). As described above, this causes the fluid to be swirled, and this swirl ensures that the fluid is forced towards the surface to be cooled and into the surface pattern, thereby bringing the fluid into contact with the entire enlarged surface area. Thereby, the enlarged surface area of the surface to be cooled can be utilised, while maintaining relatively large dimensions of the flow path(s) defined by the flow cell(s).

Accordingly, the combination of designing the flow cell(s) to provide at least one change in the direction of flow of the fluid flowing through the flow cell(s), and providing the surface pattern of raised and depressed surface portions on the surface to be cooled, allows efficient heat transfer from the surface to be cooled to the fluid flowing in the flow cell(s), without risking clogging of the flow path(s) of the flow cell(s), and without introducing a large pressure drop of the fluid flowing through the flow cell(s). This is very advantageous. Furthermore, the combination of the increased surface area provided by the surface pattern, and the mixture of the fluid caused by the swirl improves the heat transfer of the flow distribution module, and thereby the cooling performance of the flow distribution module.

The surface pattern may, e.g., be provided by means of punching, stamping, rolling or similar techniques. In this case the surface pattern is formed directly in a surface of the cover plate during manufacture of the cover plate.

It should be noted that, even though the description above refers to 'a surface to be cooled' and 'the surface to be cooled', the flow distribution module of the invention may be used for cooling two or more surfaces, each being arranged adjacent to one or more flow cells in an appropriate manner.

The flow distribution module may further comprise an inlet manifold and an outlet manifold, and the housing may define at least two flow cells, the inlet opening of each flow cell being fluidly connected to the inlet manifold and the outlet opening of each flow cell being fluidly connected to the outlet manifold, each flow cell thereby establishing a fluid connection between the inlet manifold and the outlet manifold. According to this embodiment, the flow cells cover various parts of the surface to be cooled, and it is thereby possible to provide more intensive cooling to some parts of the surface than to other parts.

The flow cells may be arranged fluidly in parallel between the inlet manifold and the outlet manifold, the flow cells thereby defining parallel flow paths between the inlet manifold and the outlet manifold. According to this embodiment, each flow cell is directly fluidly connected to the inlet manifold via its inlet opening, and directly fluidly connected to the outlet manifold via its outlet opening. Thereby the fluid entering each of the flow cells has the same temperature. This allows uniform cooling to be provided across the surface to be cooled, i.e. temperature variations across the surface can be minimised.

As an alternative, two or more of the flow cells may be arranged fluidly in series. In this case the inlet opening of a first flow cell may be fluidly connected directly to the inlet manifold, the outlet opening of the first flow cell may be fluidly connected to the inlet opening of a second flow cell, and the outlet opening of the second flow cell may be fluidly connected directly to the outlet manifold. Thus, the first flow cell is fluidly connected to the outlet manifold via the second flow cell, and the second flow cell is fluidly connected to the inlet manifold via the first flow cell.

The inlet manifold and the outlet manifold may be defined by the housing. According to this embodiment, the housing, the inlet manifold, the outlet manifold and the flow cells may be formed as a single part, and the cover plate may be mounted on this part, thereby forming a closed unit with the flow cells and the manifolds arranged inside the closed unit. This allows the manufacturing costs of the flow distribution module to be minimised.

At least one flow cell may define a meandering flow path. According to the this embodiment, the change(s) in direction of flow of the fluid flowing through the flow cell(s) is/are primarily caused by the fluid following the meandering path. As an alternative, the change(s) in direction of flow of the fluid flowing through the flow cell(s) may be obtained in another way. For instance, each flow cell may comprise a surface arranged opposite and facing the surface to be cooled, the surface of the flow cell being provided with a surface pattern which, e.g., is a mirror image of the surface pattern provided on the surface to be cooled, or a surface pattern which is identical or similar to the surface pattern provided on the surface to be cooled. If the two surfaces are arranged sufficiently close to each other, the surface patterns of the surface to be cooled and the surface of the flow cell, respectively, may cooperate to cause the fluid flow to change direction as the fluid flows through the flow cell. In the case that the two surface patterns are identical, the surface patterns may, e.g., be arranged in such a manner that raised surface portions are arranged opposite to each other and depressed surface portions are arranged opposite to each other. In this case the distance between the surfaces varies across the surface patterns, and this variation gives rise to the swirl of the fluid flowing through the flow cell. As an alternative, the surface patterns may be arranged in such a manner that raised surface portions of one surface pattern are arranged opposite depressed surface portions of the other surface pattern, and vice versa. In this case the distance between the surfaces is substantially constant across the surface patterns, but the direction of flow of the fluid is changes as the fluid follows the raised and depressed surface portions. The change in direction of the fluid flow may occur in a direction towards and away from the surfaces, and/or in a direction substantially parallel to the surfaces, in order to 'navigate' the fluid around the surface structures defined by the surface patterns.

The surface pattern may define a sub-pattern which is repeated along at least one direction of the surface pattern. The sub-pattern is it may be repeated along two or more directions of the surface pattern.

The sub-pattern is repeated along two or more directions of the surface pattern. The surface pattern may comprise 'islands' of raised surface portions surrounded by depressed surface portions. In this case the surface pattern may, e.g., comprise structures of pyramid-like, conical, spherical or hemispherical shape. The raised surface portions and the depressed surface portions have essentially the same shape, for instance the raised surface portion being pyramids protruding from the surface to be cooled, and the depressed surface portions being pyramid shaped depressions in the surface.

The surface pattern may even be or comprise fins and/or pins.

In the case that the raised and depressed surface portions have rounded shapes, such as sinusoidal, spherical or hemispherical, the risk of corrosion of the surface structure during operation is minimised.

The raised surface portions of the surface pattern may define raised height levels and the depressed surface portions of the surface pattern may define depressed height levels. In this case an average height difference between the raised height levels and the depressed height levels may be within the interval of 0.2 mm to 5 mm, such as within the interval 0.5 mm to 3 mm, such as within the interval 0.7 mm to 2 mm, such as approximately 1 mm. According to this embodiment, the raised height levels could be the levels of top points of pyramids, cones, ridges, hemispheres, etc. forming the raised surface portions. Thus, the raised height levels may be regarded as local maxima of the surface pattern. Similarly, the depressed height levels could be the levels of local minima of the surface pattern, defined by the depressed surface pattern. Thereby the average height difference between the raised height levels and the depressed height levels is a measure for the depth of the surface pattern, i.e. the typical difference between extremes of the surface pattern. Thus, according to this embodiment, the depth of the surface pattern is relatively low, i.e. the structures of the surface pattern are relatively small. When the structures of the surface pattern are small, it is difficult to ensure that the fluid flowing through the flow cell(s) enters into the surface pattern, and it is therefore in particular an advantage that the fluid is swirled due to the at least one change of direction of the fluid flow in this case.

Alternatively or additionally, the average height difference between the raised height levels and the depressed height levels may be within the interval 10% to 60%, such as within the interval 20% to 55%, such as within the interval 30% to 50% of an average height of a flow channel defined by the flow cell(s). According to this embodiment, the dimensions of the structures of the surface structure are significantly smaller than the typical dimensions of the flow path(s) defined by the flow cell(s). In this case it is also a great advantage that the fluid is swirled due to the at least one change of direction of the fluid flow, thereby forcing the fluid into the surface structure and ensuring that the enlarged surface area is utilised.

Alternatively or additionally, a median surface level over the area provided with the surface pattern may define a surface plane. The median height of peaks defined by the raised surface portions, measured from the surface plane, may define a peak plane. Similarly, the median depth of troughs defined by the depressed surface portions, measured from the surface plane, may define a trough plane. In this case the separation between the peak plane and the trough plane, measured in a direction normal to the surface plane, may be within the interval 0.2 mm to 5 mm, such as within the interval 0.5 mm to 3 mm, such as within the interval 0.7 mm to 2 mm, such as approximately 1 mm. This is also a measure for the 'depth' or roughness of the surface pattern, and the remarks set forth above are equally applicable here.

The cover plate may be mounted on the housing in a substantially fluid tight manner. This may, e.g., be obtained by welding or gluing the cover plate onto the housing. Alternatively, the cover plate may be mounted on the housing in a reversible manner, e.g. by means of screws or bolts. In this case a sealing element, such as an o-ring, may advantageously be arranged between the housing and the cover plate in order to ensure that the assembly is fluid tight.

The flow distribution module may further comprise at least one power module mounted on a surface the cover plate which is opposite to the surface having the surface pattern provided thereon. The power module may, e.g., be a semiconductor power module. Power modules produce heat. By mounting the power module on the cover plate, the power module can be cooled by means of the fluid flowing in the flow cell(s) of the flow distribution module.

The power module(s) may be arranged in a region of the cover plate where the surface pattern is provided. Thereby the power module is efficiently cooled, as described above.

The surface to be cooled may comprise two or more separate regions, each being provided with a surface pattern, the patterned regions being separated by regions with no surface pattern. In this case two or more power modules, or other heat producing elements, may be mounted on the cover plate, and each power module may be mounted at a position corresponding to the position of a patterned region. Furthermore, a zone along the edge of the cover plate may be left without surface pattern in order to ensure that a proper sealing can be provided between the housing and the cover plate.

At least the cover plate may be made from a metal, such as copper.

### BRIEF DESCRIPTION OF THE DRAWINGS

The invention will now be described in further detail with reference to the accompanying drawings in which
Fig. 1 is a perspective view of a flow distribution module according to an embodiment of the invention,
Fig. 2 is a perspective view of a housing for a flow distribution module according to an embodiment of the invention,
Fig. 3 is a perspective view of a cover plate for a flow distribution module according to an embodiment of the invention,
Fig. 4 is a perspective view of a part of a cover plate for a flow distribution module according to an alternative embodiment of the invention,
Fig. 5 illustrates a surface pattern for the cover plates of Figs. 3 or 4,
Figs. 6-8 are cross sectional views of a flow distribution module according to a first embodiment of the invention, seen from various angles, and
Fig. 9 is a cross sectional view of a flow distribution module according to a second embodiment of the invention.

### DETAILED DESCRIPTION OF THE DRAWINGS

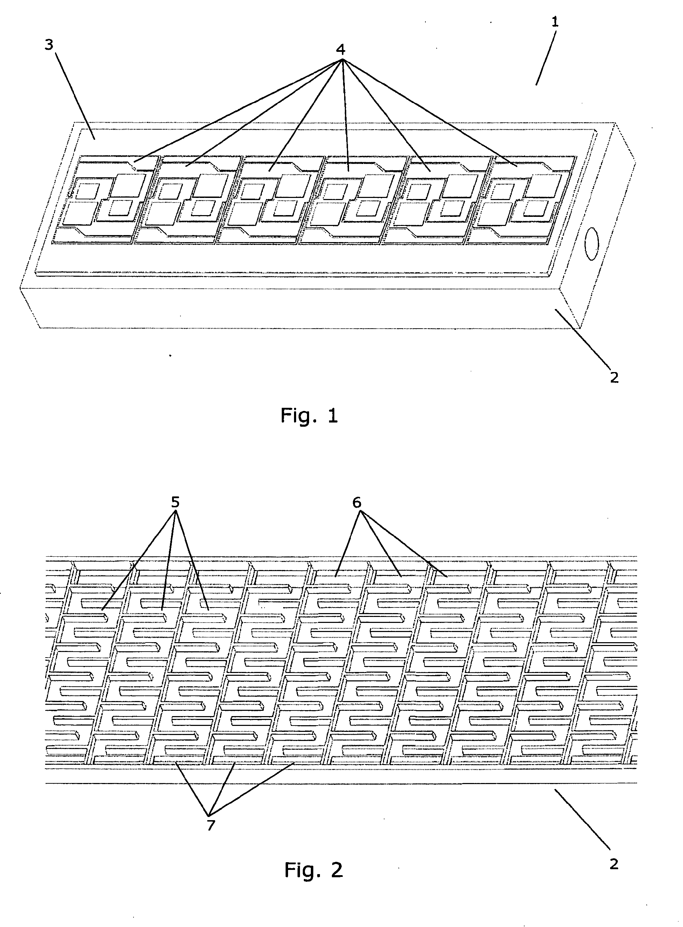

Fig. 1 is a perspective view of a flow distribution module 1 according to an embodiment of the invention. The flow distribution module 1 comprises a housing 2 and a cover plate 3 mounted on the housing 2 in a substantially fluid tight manner. The housing 2 defines one or more flow cells (not visible) arranged to cause fluid to flow over a surface of the cover plate 3 which faces the interior of the housing 2. This will be described further below.

Six heat producing power modules 4 are mounted on the cover plate 3. The power modules 4 are thereby cooled by means of fluid flowing through the flow cell(s) defined by the housing 2.

Fig. 2 is a perspective view of a housing 2 for a flow distribution module according to an embodiment of the invention. The housing 2 of Fig. 2 may, e.g., be used for the flow distribution module 1 of Fig. 1.

The housing 2 defines a plurality of flow cells 5. Each flow cell 5 comprises an inlet opening 6, which is fluidly connected to an inlet manifold (not visible), and an outlet opening 7, which is fluidly connected to an outlet manifold (not visible). Thus, each flow cell 5 establishes a flow path between the inlet manifold and the outlet manifold, and the flow paths are arranged fluidly in parallel between the inlet manifold and the outlet manifold.

Each of the flow cells 5 defines a meandering flow path. Thereby fluid flowing through a flow cell 5 from the inlet opening 6 to the outlet opening 7 is caused to perform a plurality of changes in the direction of flow of the fluid. As described above, this causes the fluid to 'swirl', thereby forcing the fluid towards a cover plate to be mounted on the housing 2 in such a manner that it covers the flow cells 5, and in such a manner that a surface of the cover plate is arranged in direct contact with fluid flowing through the flow cells 5.

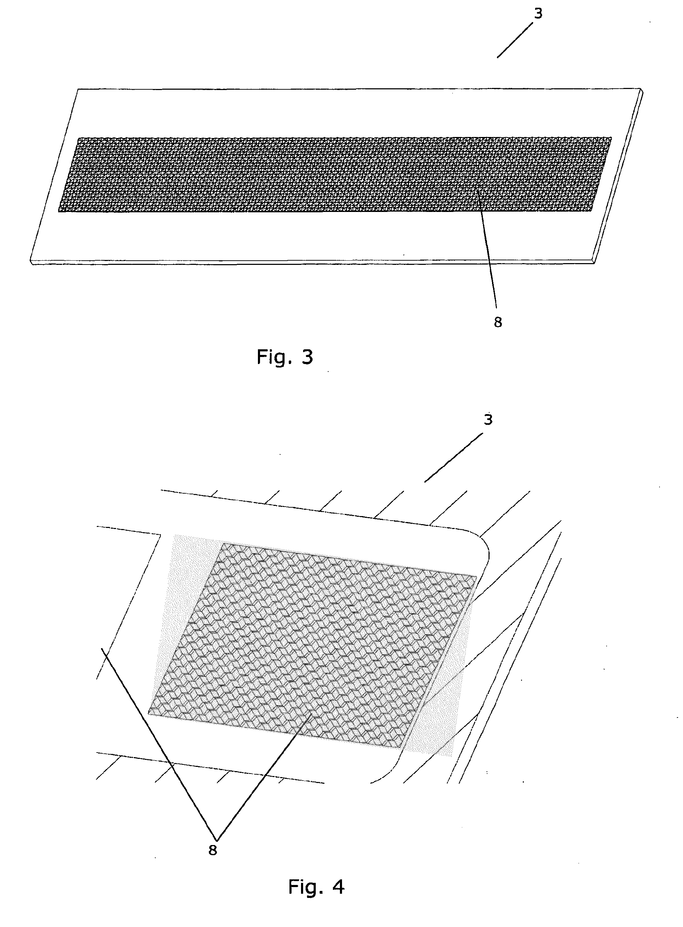

Fig. 3 is a perspective view of a cover plate 3 for a flow distribution module according to an embodiment of the invention. The cover plate 3 of Fig. 3 may, e.g., be used in the flow distribution module 1 of Fig. 1, and/or it may be mounted on the housing 2 of Fig. 2 in order to form a flow distribution module.

A centre region of the cover plate 3 is provided with a surface pattern 8 of raised and depressed surface portions. Thereby the surface area in the region of the surface pattern 8 is enlarged, and it is therefore possible to provide efficient cooling to heat producing elements, such as the power modules 4 shown in Fig. 1, mounted on the opposite side of the cover plate 3.

When the cover plate 3 is mounted on a housing in order to form a flow distribution module, it is mounted in such a manner that the surface pattern 8 faces the flow cell(s), e.g. the flow cells 5 shown in Fig. 2, defined inside the housing. Thereby the fluid flowing through the flow cell(s) is brought into contact with the surface pattern 8. As described above, the fluid flowing through the flow cell(s) is caused to swirl due to one or more changes in the direction of flow of the fluid, e.g. by means of the meandering flow paths shown in Fig. 2. The swirl of the fluid forces the fluid into the surface pattern 8, thereby ensuring that it is brought into contact with the entire enlarged surface area. Furthermore, this is achieved without having to make the dimensions of the flow path(s) small. This is an advantage, because small flow paths introduce the risk of clogging of the flow paths, and introduce a large pressure drop across the flow cell.

Fig. 4 is a perspective view of a part of a cover plate 3 for a flow distribution module according to an alternative embodiment of the invention. The cover plate 3 of Fig. 4 is very similar to the cover plate 3 of Fig. 3, and the remarks set forth above are therefore equally applicable here.

Whereas the cover plate 3 of Fig. 3 comprises a single region being provided with surface pattern 8, the cover plate 3 of Fig. 4 is provided with several regions, each being provided with a surface pattern 8. One surface pattern 8 is shown fully, and a part of the next surface pattern 8 can be seen. The cover plate 3 of Fig. 4 may have a number of heat producing elements, such as power modules, mounted on the opposite side of the cover plate 3, each heat producing element being mounted in a region corresponding to a region being provided with a surface pattern 8. Thereby the surface patterns 8 are only provided in the regions where cooling is required, and the remaining parts of the cover plate 3 are left substantially plane.

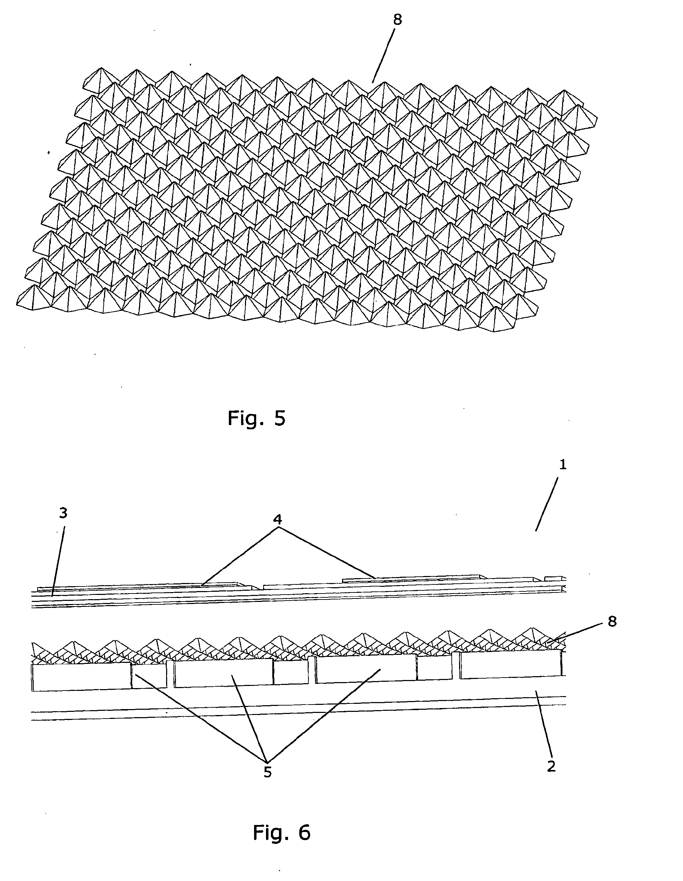

Fig. 5 illustrates a surface pattern 8 for the cover plates 3 of Figs. 3 or 4. The surface pattern 8 comprises a plurality of pyramids with inverted pyramid shapes there between. The pyramids form raised surface portions, and the inverted pyramid shapes form depressed surface portions of the surface pattern 8. The surface pattern 8 illustrated in Fig. 5 increases the surface area of the surface by a factor √2.

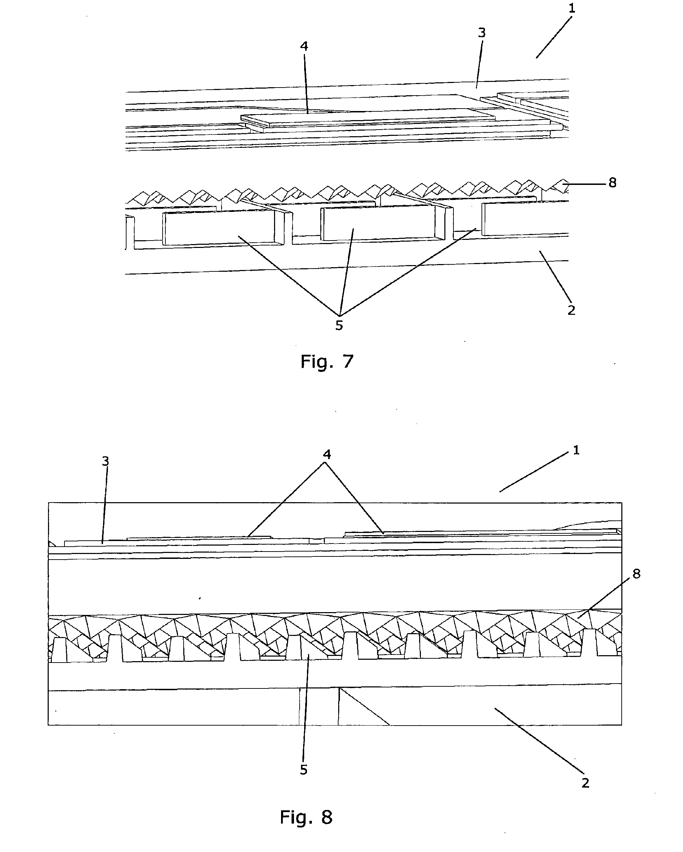

Figs. 6-8 are cross sectional views of a flow distribution module 1 according to a first embodiment of the invention, seen from various angles. The flow distribution module 1 comprises the housing 2 of Fig. 2 and the cover plate 3 of Fig. 3 or the cover plate 3 of Fig. 4. The cover plate 3 is mounted on the housing 2 in a substantially fluid tight manner, and in such a manner that the surface pattern 8 of the cover plate 3 faces the flow cells 5 of the housing 2.

It is clear from Figs. 6-8 that the height of the flow paths defined by the flow cells 5 is significantly larger than the depth or roughness of the surface pattern 8. Thereby the pressure drop of fluid flowing through the flow cells 5 is minimised. Furthermore, the risk of clogging of the flow cells 5 is minimised.

However, the swirl of the fluid provided by the plurality of changes of direction of the fluid flow, caused by the meandering flow path, ensures that the fluid is forced into the surface pattern 8, thereby bringing it into contact with the entire enlarged surface area. As a consequence, the surface of the cover plate 3 being provided with the surface pattern 8 can be efficiently cooled.

In Figs. 6-8 it appears that the surface pattern 8 is provided over the entire area covered by the flow cells 5. It could, however, be envisaged that the surface pattern 8 is removed at the positions corresponding to the side walls of the meandering structure of the flow cells 5. Thereby it is possible to design a possible gap between the surface to be cooled and the side walls of the flow cells 5 in such a manner that a desired bypass flow is provided. Thereby the cooling performance of the flow distribution module 1 can be optimised, while the pressure drop of fluid flowing through the flow distribution module 1 is minimised. As an alternative, the side walls of the meandering structure of the flow cells 5 could be designed in such a manner that they follow the surface pattern 8 of the surface to be cooled, thereby provided appropriate bypass passages.

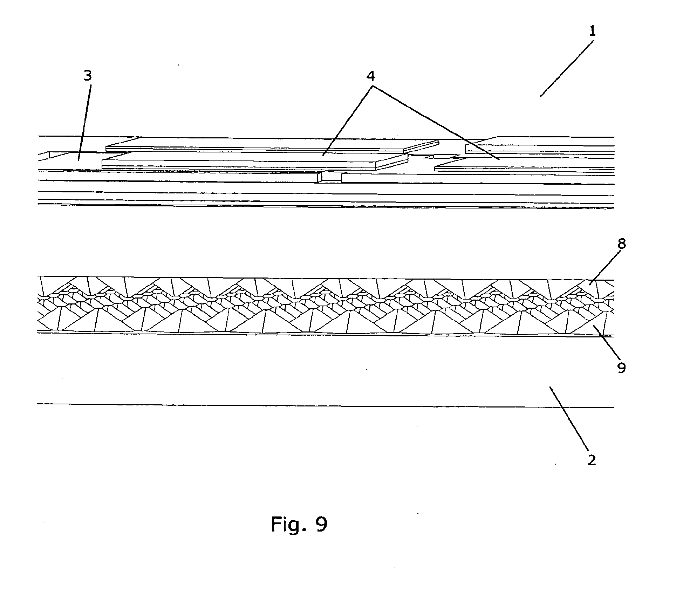

Fig. 9 is a cross sectional view of a flow distribution module 1 according to a second embodiment of the invention. In the embodiment of Fig. 9, the cover plate 3 is identical or similar to the cover plate 3 of the embodiment of Figs. 6-8, and it will therefore not be described in detail here.

The housing 2 defines a flow cell comprising a surface which is provided with a surface pattern 9 which is essentially a mirror image of the surface pattern 8 provided on the cover plate 3. When fluid is flowing in the flow cell, it is forced to follow passages defined between raised surface portions of the surface pattern 8 provided on the cover plate 3 and the raised surface portions of the surface pattern 9 provided in the flow cell. Thereby the fluid is forced to perform a plurality of changes in the direction of flow. Accordingly, the fluid is forced into the surface pattern 8 provided on the cover plate 3, and thereby the fluid is brought into contact with the entire enlarged surface area provided by the surface structure 8, and ensuring an efficient cooling of the cover plate 3. This is obtained without having to decrease the distance between the surface patterns 8, 9, thereby increasing the risk of clogging and excessive pressure drop of the fluid flowing through the flow cell.

In the flow distribution module 1 of Fig. 9, the raised surface portions of surface pattern 8 are arranged opposite raised surface portions of surface pattern 9, and depressed surface portions of surface pattern 8 are arranged opposite depressed surface portions of surface portions of surface pattern 9. Thereby the distance between the surfaces, and thereby the dimensions of the flow path defined by the flow cell, varies across the surface patterns 8, 9. This variation provides the 'swirl' of the fluid flowing through the flow cell.

As an alternative, the surface patterns 8, 9 could be shifted relative to each other, in such a way that the raised surface portions of surface pattern 8 could be arranged opposite depressed surface portions of surface pattern 9, and depressed surface portions of surface pattern 8 could be arranged opposite raised surface portions of surface pattern 9. In this case the 'swirl' of the fluid is provided by the fluid 'navigating' around the raised surface portions of the surface patterns 8, 9. This 'navigation' could take place in a direction towards and away from the surface patterns 8, 9, and/or in a direction substantially parallel to the surface patterns 8, 9, i.e. sideways through the flow cell.

## Claims

1. A flow distribution module (1) for distributing a flow of fluid over a surface to be cooled, said flow distribution module (1) comprising:
- a housing (2) defining at least one flow cell (5), each flow cell (5) having an inlet opening (6) arranged to receive fluid to the flow cell (5) and an outlet opening (7) arranged to deliver fluid from the flow cell (5), the flow cell(s) (5) being positioned in such a way that a flow of fluid flowing through a flow cell (5) from the inlet opening (6) to the outlet opening (7) is conveyed over the surface to be cooled, each flow cell (5) being formed to cause at least one change in the direction of flow of the fluid flowing through the flow cell (5), thereby forcing fluid towards the surface to be cooled,
- a cover plate (3) arranged adjacent to the flow cell(s) (5), said cover plate (3) defining the surface to be cooled, wherein
at least a part of the surface to be cooled defined by the cover plate (3) is provided with a surface pattern (8) of raised and depressed surface portions, thereby providing an enlarged surface area of the surface to be cooled, said surface pattern (8) defining a sub-pattern which is repeated along two or more directions of the surface pattern (8), and **characterized in that** the raised surface portions and the depressed surface portions having the same shape.

2. A flow distribution module (1) according to claim 1, further comprising an inlet manifold and an outlet manifold, wherein the housing (2) defines at least two flow cells (5), the inlet opening (6) of each flow cell (5) being fluidly connected to the inlet manifold and the outlet opening (7) of each flow cell (5) being fluidly connected to the outlet manifold, each flow cell (5) thereby establishing a fluid connection between the inlet manifold and the outlet manifold.

3. A flow distribution module (1) according to claim 2, wherein the flow cells (5) are arranged fluidly in parallel between the inlet manifold and the outlet manifold, the flow cells (5) thereby defining parallel flow paths between the inlet manifold and the outlet manifold.

4. A flow distribution module (1) according to claim 2 or 3, wherein the inlet manifold and the outlet manifold are defined by the housing (2).

5. A flow distribution module (1) according to any of the preceding claims, wherein at least one flow cell (5) defines a meandering flow path.

6. A flow distribution module (1) according to any of the preceding claims, wherein the raised surface portions of the surface pattern (8) define raised height levels and the depressed surface portions of the surface pattern define depressed height levels, and wherein an average height difference between the raised height levels and the depressed height levels is within the interval of 0.2 mm to 5 mm.

7. A flow distribution module (1) according to any of the preceding claims, wherein the raised surface portions of the surface pattern (8) define raised height levels and the depressed surface portions of the surface pattern (8) define depressed height levels, and wherein an average height difference between the raised height levels and the depressed height levels is within the interval 10% to 60% of an average height of a flow channel defined by the flow cell(s) (5).

8. A flow distribution module (1) according to any of the preceding claims, wherein the cover plate (3) is mounted on the housing (2) in a substantially fluid tight manner.

9. A flow distribution module (1) according to any of the preceding claims, further comprising at least one power module (4) mounted on a surface the cover plate (3) which is opposite to the surface having the surface pattern (8) provided thereon. q

10. A flow distribution module (1) according to claim 9, wherein the power module(s) (4) is/are arranged in a region of the cover plate (3) where the surface pattern (8) is provided.

## Patentansprüche

1. Durchflussverteilungsmodul (1) zum Verteilen einer Fluidströmung über eine Oberfläche, die gekühlt werden soll, wobei das Durchflussverteilungsmodul (1) umfasst:
- ein Gehäuse (2), das mindestens eine Strömungszelle (5) definiert, wobei jede Strömungszelle (5) eine Einlassöffnung (6), die angeordnet ist, um ein Fluid in die Strömungszelle (5) aufzunehmen, und eine Auslassöffnung (7), die angeordnet ist, um ein Fluid aus der Strömungszelle (5) abzugeben, aufweist, wobei die Strömungszelle(n) (5) derartig positioniert ist/sind, dass eine Fluidströmung, die von der Einlassöffnung (6) zu der Auslassöffnung (7) durch eine Strömungszelle (5) strömt, über die Oberfläche, die gekühlt werden soll, befördert wird, wobei jede Strömungszelle (5) gebildet ist, um mindestens eine Richtungsänderung der Fluidströmung, die durch die Strömungszelle (5) strömt, zu veranlassen, wodurch das Fluid auf die Oberfläche, die gekühlt werden soll, gedrückt wird,
- eine Deckplatte (3), die benachbart zu der/den Strömungszelle(n) (5) angeordnet ist/sind, wobei die Deckplatte (3) die Oberfläche, die gekühlt werden soll, definiert, wobei
mindestens ein Teil der Oberfläche, die gekühlt werden soll und die durch die Deckplatte (3) definiert ist, mit einem Oberflächenmuster (8) von erhabenen und abgesenkten Oberflächenabschnitten versehen ist, wodurch ein vergrößerter Oberflächenbereich der Oberfläche, die gekühlt werden soll, bereitgestellt wird, wobei das Oberflächenmuster (8) ein Untermuster definiert, das entlang zweier oder mehrerer Richtungen des Oberflächenmusters (8) wiederholt wird, und **dadurch gekennzeichnet ist, dass** die erhabenen Oberflächenabschnitte und die abgesenkten Oberflächenabschnitte dieselbe Form aufweisen.

2. Durchflussverteilungsmodul (1) nach Anspruch 1, das ferner einen Einlassverteiler und einen Auslassverteiler umfasst, wobei das Gehäuse (2) mindestens zwei Strömungszellen (5) definiert, wobei die Einlassöffnung (6) jeder Strömungszelle (5) fluidtechnisch mit dem Einlassverteiler verbunden ist und die Auslassöffnung (7) jeder Strömungszelle (5) fluidtechnisch mit dem Auslassverteiler verbunden ist, wodurch jede Strömungszelle (5) eine Fluidverbindung zwischen dem Einlassverteiler und dem Auslassverteiler aufbaut.

3. Durchflussverteilungsmodul (1) nach Anspruch 2, wobei die Strömungszellen (5) fluidtechnisch parallel zwischen dem Einlassverteiler und dem Auslassverteiler angeordnet sind, wobei die Strömungszellen (5) dadurch parallele Strömungspfade zwischen dem Einlassverteiler und dem Auslassverteiler definieren.

4. Durchflussverteilungsmodul (1) nach Anspruch 2 oder 3, wobei der Einlassverteiler und der Auslassverteiler durch das Gehäuse (2) definiert sind.

5. Durchflussverteilungsmodul (1) nach einem der vorhergehenden Ansprüche, wobei mindestens eine Strömungszelle (5) einen mäandernden Strömungspfad definiert.

6. Durchflussverteilungsmodul (1) nach einem der vorhergehenden Ansprüche, wobei die erhabenen Oberflächenabschnitte des Oberflächenmusters (8) erhabene Höhenniveaus definieren und die abgesenkten Oberflächenabschnitte des Oberflächenmusters abgesenkte Höhenniveaus definieren, und wobei die durchschnittliche Höhendifferenz zwischen den erhabenen Höhenniveaus und den abgesenkten Höhenniveaus innerhalb des Intervalls von 0,2 mm bis 5 mm liegt.

7. Durchflussverteilungsmodul (1) nach einem der vorhergehenden Ansprüche, wobei die erhabenen Oberflächenabschnitte des Oberflächenmusters (8) erhabene Höhenniveaus definieren und die abgesenkten Oberflächenabschnitte des Oberflächenmusters (8) abgesenkte Höhenniveaus definieren, und wobei die durchschnittliche Höhendifferenz zwischen den erhabenen Höhenniveaus und den abgesenkten Höhenniveaus innerhalb des Intervalls von 10 % bis 60 % einer durchschnittlichen Höhe eines Strömungskanals, der durch die Strömungszelle(n) (5) definiert ist, liegt.

8. Durchflussverteilungsmodul (1) nach einem der vorhergehenden Ansprüche, wobei die Deckplatte (3) auf dem Gehäuse (2) in einer im Wesentlichen fluiddichten Art befestigt ist.

9. Durchflussverteilungsmodul (1) nach einem der vorhergehenden Ansprüche, das ferner mindestens ein Leistungsmodul (4) umfasst, das auf einer Oberfläche der Deckplatte (3) befestigt ist, die gegenüber der Oberfläche liegt, die das Oberflächenmuster (8), das darauf bereitgestellt ist, aufweist.

10. Durchflussverteilungsmodul (1) nach Anspruch 9, wobei das/die Leistungsmodul(e) (4) in einem Bereich der Deckplatte (3) angeordnet ist/sind, wo das Oberflächenmuster (8) bereitgestellt ist.

## Revendications

1. Module de distribution de flux (1) pour distribuer un flux de fluide sur une surface à refroidir, ledit module de distribution (1) comprenant:
un boîtier (2) qui définit au moins une cellule à flux (5), chaque cellule à flux (5) comportant une ouverture d'entrée (6) agencée de manière à recevoir un fluide à la cellule à flux (5), et une ouverture de sortie (7) agencée de manière à délivrer un fluide à partir de la cellule à flux (5), la (les) cellule (s) à flux (5) étant positionnée(s) de telle sorte qu'un flux de fluide s'écoulant à travers une cellule à flux (5) à partir de l'ouverture d'entrée (6) jusqu'à l'ouverture de sortie (7) soit transporté sur la surface à refroidir, chaque cellule à flux (5) étant formée de manière à entraîner au moins un changement dans la direction du flux de fluide qui s'écoule à travers la cellule à flux (5), forçant de ce fait un fluide en direction de la surface à refroidir,
une plaque de couverture (3) qui est agencée à proximité de la (des) cellule(s) à flux (5), ladite plaque de couverture (3) définissant la surface à refroidir,
dans lequel au moins une partie de la surface à refroidir définie par la plaque de couverture (3) comporte un motif de surface (8) de parties de surface surélevées et creusées, formant de ce fait une aire de surface agrandie de la surface à refroidir, ledit motif de surface (8) définissant un motif secondaire qui est répété le long de deux ou plus de deux directions du motif de surface (8), et **caractérisé en ce que** les parties de surface surélevées et les parties de surface creusées présentent la même configuration.

2. Module de distribution de flux (1) selon la revendication 1, comprenant en outre un collecteur d'entrée et un collecteur de sortie, dans lequel le boîtier (2) définit au moins deux cellules à flux (5), l'ouverture d'entrée (6) de chaque cellule à flux (5) étant connectée de façon fluidique au collecteur d'entrée et l'ouverture de sortie (7) de chaque cellule à flux (5) étant connectée de façon fluidique au collecteur de sortie, chaque cellule à flux (5) établissant de ce fait une connexion fluidique entre le collecteur d'entrée et le collecteur de sortie.

3. Module de distribution de flux (1) selon la revendication 2, dans lequel les cellules à flux (5) sont agencées de façon fluidique en parallèle entre le collecteur d'entrée et le collecteur de sortie, les cellules à flux (5) définissant de ce fait des chemins de flux parallèles entre le collecteur d'entrée et le collecteur de sortie.

4. Module de distribution de flux (1) selon la revendication 2 ou 3, dans lequel le collecteur d'entrée et le collecteur de sortie sont définis par le boîtier (2).

5. Module de distribution de flux (1) selon l'une quelconque des revendications précédentes, dans lequel au moins une cellule à flux (5) définit un chemin de flux sinueux.

6. Module de distribution de flux (1) selon l'une quelconque des revendications précédentes, dans lequel les parties de surface surélevées du motif de surface (8) définissent des niveaux de hauteur surélevés et les parties de surface creusées du motif de surface définissent des niveaux de hauteur creusés, et dans lequel une différence de hauteur moyenne entre les niveaux de surface surélevés et les niveaux de surface creusés se situe à l'intérieur d'un intervalle de 0,2 mm à 5 mm.

7. Module de distribution de flux (1) selon l'une quelconque des revendications précédentes, dans lequel les parties de surface surélevées du motif de surface (8) définissent des niveaux de hauteur surélevés et les parties de surface creusées du motif de surface (8) définissent des niveaux de hauteur creusés, et dans lequel une différence de hauteur moyenne entre les niveaux de surface surélevés et les niveaux de surface creusés se situe à l'intérieur d'un intervalle de 10 % à 60 % d'une hauteur moyenne d'un canal de flux qui est défini par la (les) cellule(s) à flux (5).

8. Module de distribution de flux (1) selon l'une quelconque des revendications précédentes, dans lequel la plaque de couverture (3) est montée sur le boîtier (2) d'une façon sensiblement étanche au fluide.

9. Module de distribution de flux (1) selon l'une quelconque des revendications précédentes, comprenant en outre au moins un module de puissance (4) qui est monté sur une surface de la plaque de couverture (3) qui est opposée à la surface comportant le motif de surface (8) formé sur celle-ci.

10. Module de distribution de flux (1) selon la revendication 9, dans lequel le(s) module(s) de puissance (4) est (sont) agencé(s) dans une région de la plaque de couverture (3) qui comporte le motif de surface (8).
